# EUROPEAN PATENT APPLICATION

(11) **EP 1 806 775 A1**
(43) Date of publication of application: **11.07.2007**
(21) Application number: 05799441.0
(22) Date of filing: 26.10.2005
(51) Int. Cl.: H01L 21/308, C30B 33/08, H01L 31/04

(54) **PROCESS FOR PRODUCING SEMICONDUCTOR SUBSTRATE, SEMICONDUCTOR SUBSTRATE FOR SOLAR APPLICATION AND ETCHING SOLUTION**

(30) Priority: 28.10.2004 JP 2004314450
(71) Applicant: Mimasu Semiconductor Industry Co., Ltd., Takasaki-shi, Gunma 370-3533 (JP); Space Energy Corporation, Taito-ku Tokyo 1100005 (JP)
(72) Inventor: TSUCHIYA, M., MIMASU SEMICONDUCTOR IND. CO., LTD., Takasaki-shi Gunma-gun, Gunma 370-3521 (JP); MASHIMO, Ikuo, MIMASU SEMICONDUCTOR IND. CO., LTD., Takasaki-shi Gunma 370-3521 (JP); KIMURA, Yoshimichi, Tokyo 1100005 (JP)
(74) Representative: Grünecker, Kinkeldey, Stockmair & Schwanhäusser Anwaltssozietät
(86) International application number: PCT/JP2005/019688
(87) International publication number: WO 2006/046601

(57) **Abstract**

Provided is: a process for producing safely at low cost a semiconductor substrate excellent in photoelectric transduction efficiency, in which a fine uneven structure suitable for a solar cell can be formed uniformly with desired size on the surface of the semiconductor substrate; a semiconductor substrate for solar application in which a uniform and fine pyramid-shaped uneven structure is provided uniformly within the surface thereof; and an etching solution for forming a semiconductor substrate having a uniform and fine uneven structure. A semiconductor substrate is etched with the use of an alkali etching solution containing at least one kind selected from the group consisting of carboxylic acids having a carbon number of 1 to 12 and having at least one carboxyl group in a molecule, and salts thereof, to thereby form an uneven structure on the surface of the semiconductor substrate.

## Description

### Technical Field

The present invention relates to a process for producing a semiconductor substrate having an uneven structure, which is used for a solar cell or the like, a semiconductor substrate for solar application, and an etching solution used in the process.

### Background Art

Recently, in order to enhance an efficiency of a solar cell, there is employed a process involving forming an uneven structure on a surface of a substrate to input incident light from the surface into the substrate efficiently. As a process for uniformly forming a fine uneven structure on the surface of the substrate, Non-patent Document 1 discloses a process involving performing anisotropic etching treatment using a mixed aqueous solution of sodium hydroxide and isopropyl alcohol with respect to the surface of a single crystal silicon substrate having a (100) plane on the surface, to form unevenness in a pyramid shape (quadrangular pyramid) composed of a (111) plane. However, this process has problems in waste water treatment, working environment, and safety because of the use of isopropyl alcohol. Further, the shape and size of unevenness are non-uniform, so it is difficult to form uniform fine unevenness in a plane.

As an etching solution, Patent Document 1 discloses an alkaline aqueous solution containing a surfactant, and Patent Document 2 discloses an alkaline aqueous solution containing a surfactant that contains octanoic acid or dodecyl acid as a main component.
Patent Document 1: JP11-233484A
Patent Document 2: JP 2002-57139A
Non-patent Document 1: Progress in Photovoltaics: Research and Applications, Vol. 4, 435-438 (1996).

### Disclosure of the Invention

### Problems to be solved by the Invention

It is an object of the present invention to provide: a safe and low-cost process for producing a semiconductor substrate excellent in a photoelectric conversion efficiency, which is capable of uniformly forming a fine uneven structure with a desired size preferable for a solar cell on the surface of a semiconductor substrate; a semiconductor substrate for solar application having a uniform and fine pyramid-shaped uneven structure in a plane; and an etching solution for forming a semiconductor substrate having a uniform and fine uneven structure.

### Means for solving the Problems

In order to achieve the above-mentioned object, a process for producing a semiconductor substrate according to the present invention is characterized by including etching a semiconductor substrate with an alkaline etching solution containing at least one kind selected from the group consisting of carboxylic acids having a carbon number of 12 or less and having at least one carboxyl in one molecule, and salts thereof, to thereby form an uneven structure on a surface of the semiconductor substrate.

The carboxylic acid is preferably one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.
In addition, the carbon number of the carboxylic acid is preferably 7 or less. A concentration of the carboxylic acid in the etching solution is preferably 0.05 to 5 mol/L.

By selecting a predetermined one or two or more kinds of carboxylic acids as the carboxylic acid in the etching solution, a size of a pyramid-shaped protrusion of an uneven structure formed on a surface of the semiconductor substrate can be regulated.

A semiconductor substrate for solar application of the present invention has an uneven structure on a surface, produced by the method according to the present invention.

Further, it is preferable that the semiconductor substrate for solar application of the present invention have a uniform and fine uneven structure in a pyramid shape on the surface of the semiconductor substrate, and the maximum side length of a bottom surface of the uneven structure be 1 µm to 20 µm. In the present invention, the maximum side length refers to an average value of one side length of a bottom surface of 10 uneven structures successively selected in a decreasing order of the shape size in the uneven structure per unit area of 266 µm x 200 µm.
The semiconductor substrate is preferably a thinned single crystal silicon substrate.

An etching solution of the present invention is for uniformly forming a fine uneven structure in a pyramid shape on a surface of a semiconductor substrate, which is an aqueous solution containing an alkali and a carboxylic acid with a carbon number of 12 or less having at least one carboxyl group in one molecule.
The etching solution preferably has a composition in which the alkali is 3 to 50% by weight, the carboxylic acid is 0.05 to 5 mol/L, and the balance thereof is water.

In addition, the carboxylic acid is preferably one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid. The carbon number of the carboxylic acid is preferably 7 or less.

### Effects of the Invention

According to the process for producing a semiconductor substrate and an etching solution of the present invention, a semiconductor substrate which is excellent in a photoelectric conversion efficiency and has a finely uniform uneven structure in a desired shape which is preferable for a solar cell can be produced safely at low cost. The semiconductor substrate for solar application of the present invention has a uniform and fine uneven structure which is preferable for a solar cell and the like, and a solar cell excellent in a photoelectric conversion efficiency can be obtained by using the semiconductor substrate.

### Brief Description of the Drawings

FIG. 1 shows pictures of results of electron micrographs of Example 1, in which part (a) shows a picture in a magnification of 500, and part (b) shows a picture in a magnification of 1,000.
FIG. 2 shows pictures of results of electron micrographs of Example 2, in which part (a) shows a picture in a magnification of 500, and part (b) shows a picture in a magnification of 1,000.
FIG. 3 shows pictures of results of electron micrographs of Example 3, in which part (a) shows a picture in a magnification of 500, and part (b) shows a picture in a magnification of 1,000.
FIG. 4 shows pictures of results of electron micrographs of Example 4, in which part (a) shows a picture in a magnification of 500, and part (b) shows a picture in a magnification of 1,000.
FIG. 5 shows pictures of results of electron micrographs of Comparative Example 1, in which part (a) shows a picture in a magnification of 500, and part (b) shows a picture in a magnification of 1,000.
FIG. 6 shows pictures of results of electron micrographs of Example 5, in which part (a) shows a picture in a magnification of 500, and part (b) shows a picture in a magnification of 1,000.
FIG. 7 shows pictures of results of electron micrographs of Example 6, in which part (a) shows a picture in a magnification of 500, and part (b) shows a picture in a magnification of 1,000.
FIG. 8 shows pictures of results of electron micrographs of Example 7, in which part (a) shows a picture in a magnification of 500, and part (b) shows a picture in a magnification of 1,000.
FIG. 9 shows a picture of an example in which an evaluation standard is excellent on a substrate surface after the etching treatment of Example 8.
FIG. 10 shows a picture of an example in which an evaluation standard is satisfactory on a substrate surface after the etching treatment of Example 8.
FIG. 11 shows a picture of an example in which an evaluation standard is acceptable on a substrate surface after the etching treatment of Example 8.
FIG. 12 shows a picture of an example in which an evaluation standard is failure on a substrate surface after the etching treatment of Example 8.
FIG. 13 shows pictures of results of electron micrographs of Example 15.
FIG. 14 shows pictures of results of electron micrographs of Example 16.
FIG. 15 shows pictures of results of electron micrographs of Example 17.
FIG. 16 shows pictures of results of electron micrographs of Example 18.

### Best Mode for Carrying out the Invention

Hereinafter, embodiments of the present invention will be described. However, these embodiments will be shown for illustrative purposes, and it is needless to say that they can be variously modified without departing from the technical idea of the present invention.

According to the process for producing a semiconductor substrate of the present invention, an alkaline solution containing at least one kind selected from the group consisting of carboxylic acids having a carbon number of 12 or less and having at least one carboxyl group in one molecule, and salts thereof is used as an etching solution, and a semiconductor substrate is soaked in the etching solution to subject the surface of the substrate to anisotropic etching, whereby a uniform and fine uneven structure is formed on the surface of the substrate.

As the above-mentioned carboxylic acid, known organic compounds each having a carbon number of 12 or less and having at least one carboxyl group in one molecule can be used widely. Although the number of carboxyl groups is not particularly limited, it is preferably 1 to 3. That is, monocarboxylic acids, dicarboxylic acids, and tricarboxylic acids are preferable. The carbon number of a carboxylic acid is 1 or more, preferably 2 or more, and more preferably 4 or more, and 12 or less, preferably 10 or less, and more preferably 7 or less. As the above-mentioned carboxylic acid, although any of chain carboxylic acids and cyclic carboxylic acids can be used, a chain carboxylic acid is preferable, and in particular, a chain carboxylic acid having a carbon number of 2 to 7 is preferable.

Examples of the chain carboxylic acid include: saturated chain monocarboxylic acids (saturated fatty acids) such as formic acid, acetic acid, propanoic acid, butanoic acid, pentanoic acid, hexanoic acid, heptanoic acid, octanoic acid, nonanoic acid, decanoic acid, undecanoic acid, dodecanoic acid, and isomers thereof, aliphatic saturated dicarboxylic acids such as oxalic acid, malonic acid, succinic acid, glutaric acid, adipic acid, pimelic acid, and isomers thereof, aliphatic saturated tricarboxylic acids such as propanetricarboxylic acid and methanetriacetic acid; unsaturated fatty acids such as acrylic acid, butenoic acid, pentenoic acid, hexenoic acid, heptenoic acid, pentadienoic acid, hexadienoic acid, heptadienoic acid, and acetylenecarboxylic acid; aliphatic unsaturated dicarboxylic acids such as butenedioic acid, pentenedioic acid, hexenedioic acid, hexenedioic acid, and acetylenedicarboxylic acid; and aliphatic unsaturated tricarboxylic acids such as aconitic acid.

Examples of the cyclic carboxylic acids include: alicyclic carboxylic acids such as cyclopropanecarboxylic acid, cyclobutanecarboxylic acid, cyclopentanecarboxylic acid, hexahydrobenzoic acid, cyclopropanedicarboxylic acid, cyclobutanedicarboxylic acid, cyclopentanedicarboxylic acid, cyclopropanetricarboxylic acid, and cyclobutanetricarboxylic acid; and aromatic carboxylic acids such as benzoic acid, phthalic acid, and benzenetricarboxylic acid.

In addition, carboxyl group-containing organic compounds each having a functional group other than a carboxyl group can also be used. Examples thereof include: oxycarboxylic acids such as glycolic acid, lactic acid, hydroacrylic acid, oxybutyric acid, glyceric acid, tartronic acid, malic acid, tartaric acid, citric acid, salicylic acid, and gluconic acid; ketocarboxylic acids such as pyruvic acid, acetoacetic acid, propionylacetic acid, and levulinic acid; and alkoxycarboxylic acids such as methoxycarboxylic acid and ethoxyacetic acid.

Preferable examples of the those carboxylic acids include acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

As the carboxylic acid in the etching solution, a carboxylic acid containing at least one carboxylic acid having a carbon number of 4 to 7 as a main component is preferable, and if required, it is preferable to add a carboxylic acid having a carbon number of 3 or less or a carboxylic acid having a carbon number of 8 or more.
The concentration of carboxylic acid in the etching solution is preferably 0.05 to 5 mol/L, and more preferably 0.2 to 2 mol/L.

In the production process of the present invention, by selecting a predetermined carboxylic acid, the size of an uneven structure to be formed on the surface of a semiconductor substrate can be varied. In particular, by using an etching solution mixed with a plurality of carboxylic acids having different carbon numbers, the size of pyramid-shaped protrusions of the uneven structure on the surface of the substrate can be regulated. As the carbon number of a carboxylic acid to be added is smaller, the size of the uneven structure becomes smaller. In order to uniformly form fine unevenness, it is preferable that the carboxylic acid to be added contain one or two or more kinds of aliphatic carboxylic acids with a carbon number of 4 to 7 as main components, and if required, other carboxylic acids.

As the above-mentioned alkaline solution, there is an aqueous solution in which an alkali is dissolved. As the alkali, any of an organic alkali and an inorganic alkali can be used. As the organic alkali, for example, a quaternary ammonium salt such as tetramethylammonium hydroxide and ammonia are preferable. As the inorganic alkali, hydroxides of alkali metals or alkaline earth metals such as sodium hydroxide, potassium hydroxide, and calcium hydroxide are preferable, and sodium hydroxide or potassium hydroxide is particularly preferable. Those alkalis may be used alone or in combination of at least two kinds. The alkali concentration in the etching solution is preferably 3 to 50% by weight, more preferably 5 to 20% by weight, and further preferably 8 to 15% by weight.

As the above-mentioned semiconductor substrate, although a single crystal silicon substrate is preferable, a semiconductor substrate of a single crystal using a semiconductor compound such as germanium and gallium arsenide can also be used.

In the process of the present invention, an etching process is not particularly limited. A semiconductor substrate is soaked or the like for a predetermined period of time, using an etching solution heated to be kept at a predetermined temperature, whereby a uniform and fine uneven structure is formed on the surface of the semiconductor substrate. Although the temperature of the etching solution is not particularly limited, a range of 70°C to 98°C is preferable. Although the etching time is not particularly limited, 15 to 30 minutes are preferable.

According to the process for producing a semiconductor substrate of the present invention, a semiconductor substrate with a uniform uneven structure in a pyramid shape can be obtained, in which the maximum side length of a bottom surface is 1 µm to 20 µm, with an upper limit value thereof is preferably 10 µm, more preferably 5 µm, and a vertex angle of a vertical cross section is 110°. Further, according to the present invention, a semiconductor substrate with a low reflectivity can be obtained at low cost.

### Examples

Hereinafter, the present invention will be described more specifically by way of examples. However, it should be appreciated that these examples are shown for illustrative purposes, and should not be interpreted in a limiting manner.

### (Example 1)

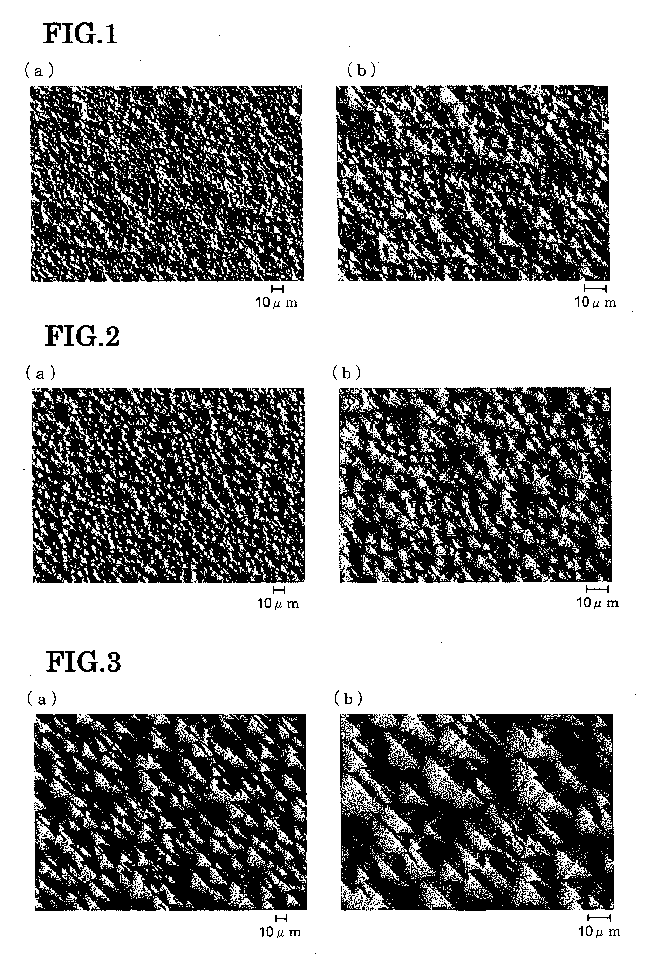

Using an etching solution, in which 30 g/L (about 0.26 mol/L) of hexanoic acid was added to 12.5% by weight of a KOH aqueous solution, as an etching solution, a single crystal silicon substrate having a (100) plane on a surface thereof was soaked at 90°C for 30 minutes. After that, the surface of the treated substrate was observed in electron micrographs. FIG. 1 shows the results of the electron micrographs. FIG. 1(a) shows the case in a magnification of 500, and FIG. 1(b) shows the case in a magnification of 1,000. Further, regarding an uneven structure per unit area of 265 µm x 200 µm, 10 uneven structures were selected successively in a decreasing order of the shape size, and the side length of a bottom surface of each pyramid structure thereof was measured. As a result, the average value of the side length, i.e., the maximum side length of the bottom surface was 9.1 µm. Table 1 shows the results of Examples 1 to 4 and Comparative Example 1.

### (Example 2)

An experiment was conducted in the same way as in Example 1 except that an etching solution in which 30 g/L (about 0.23 mol/L) of heptanoic acid was added in place of hexanoic acid. FIG. 2 shows the results of electron micrographs. Further, the maximum side length of a bottom surface of an uneven structure was 11.0 µm.

### (Example 3)

An experiment was conducted in the same way as in Example 1 except that an etching solution in which 30 g/L (about 0.21 mol/L) of octanoic acid was added in place of hexanoic acid. FIG. 3 shows the results of electron micrographs. Further, the maximum side length of a bottom surface of an uneven structure was 21.1 µm.

### (Example 4)

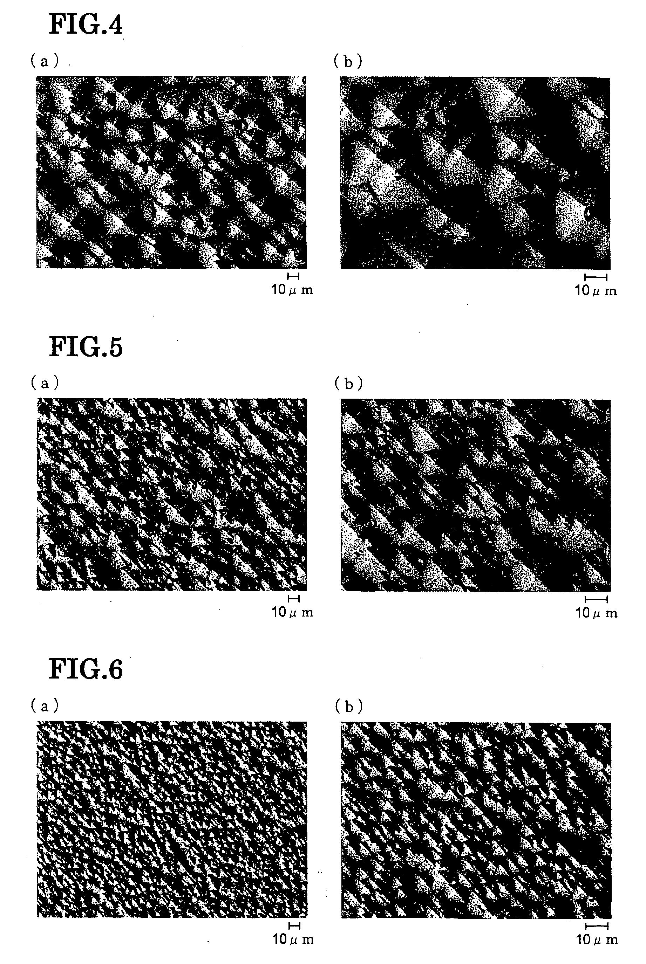

An experiment was conducted in the same way as in Example 1 except that an etching solution in which 30 g/L (about 0.19 mol/L) of nonanoic acid was added in place of hexanoic acid. FIG. 4 shows the results of electron micrographs. Further, the maximum side length of a bottom surface of an uneven structure was 32.1 µm.

### (Comparative Example 1)

An experiment was conducted in the same way as in Example 1 except that an etching solution in which isopropyl alcohol (IPA) was added in place of hexanoic acid so that 10% by weight of IPA was contained. FIG. 5 shows the results of electron micrographs. Further, the maximum side length of a bottom surface of an uneven structure was 24.8 µm.

**[Table 1]**

| | Composition of etching solution | | Unevenness of substrate | |
|---|---|---|---|---|
| | Carboxylic acid | KOH concentration | Maximum side length of bottom surface | Uniformity |
| Example 1 | Hexanoic acid | 12.5% | 9.1 µm | Uniform |
| Example 2 | Heptanoic acid | 12.5% | 11.0 µm | Uniform |
| Example 3 | Octanoic acid | 12.5% | 21.1 µm | Uniform |
| Example 4 | Nonanoic acid | 12.5% | 32.1 µm | Uniform |
| Comparative Example 1 | IPA | 12.5% | 24.8 µm | Non-uniform |

As shown in FIGS. 1 to 4 and Table 1, in Examples 1 to 4 using the etching solution of the present invention, an uneven structure having uniform and fine pyramid-shaped protrusions was formed uniformly over the entire surface of the substrate. Further, the size of the pyramid-shaped protrusions changed in accordance with the carbon number of the aliphatic carboxylic acid to be contained. Further, as a result of measuring the reflectance at a wavelength of 800 nm of the substrates obtained in Examples 1 to 4, the reflectance was 7 to 8% on average. Thus, extremely good results were obtained.
On the other hand, as shown in FIG. 5 and Table 1, regarding the etching solution with isopropanol added thereto, the size of the pyramid-shaped protrusions was irregular, and a number of overlapped pyramid shapes were observed.

### (Example 5)

Using an etching solution, in which heptanoic acid and nonanoic acid were added to 12.5% by weight of a KOH aqueous solution, as an etching solution, an experiment was conducted in the same way as in Example 1. The addition amounts of heptanoic acid and nonanoic acid were 60g/L and 30g/L, respectively. FIG. 6 shows the results of electron micrographs. Table 2 shows the results of Examples 5 to 7.

### (Example 6)

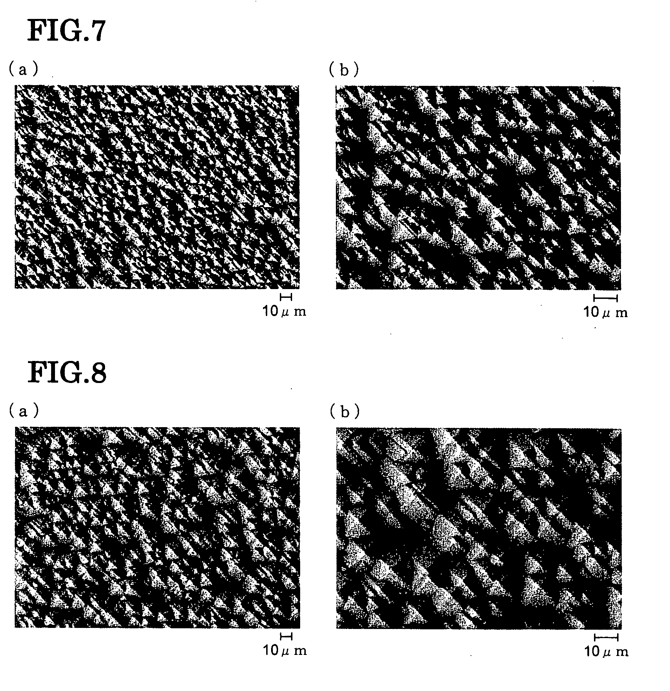

An experiment was conducted in the same way as in Example 5 except that the addition amounts of heptanoic acid and nonanoic acid were changed to 30g/L, respectively. FIG. 7 shows the results of electron micrographs.

### (Example 7)

An experiment was conducted in the same way as in Example 5 except that the addition amounts of heptanoic acid and nonanoic acid were changed to 30g/L and 60g/L, respectively. FIG. 8 shows the results of electron micrographs.

**[Table 2]**

| | Composition of etching solution | | Unevenness of substrate | |
|---|---|---|---|---|
| | Carboxylic acid [Mass ratio] | KOH concentration | Maximum side length of bottom surface | Uniformity |
| Example 5 | Heptanoic acid + Nonanoic acid[2:1] | 12.5% | 11.5 µm | Uniform |
| Example 6 | Heptanoic acid + Nonanoic acid[1:1] | 12.5% | 15.0 µm | Uniform |
| Example 7 | Heptanoic acid + Nonanoic acid[1:2] | 12.5% | 21.1 µm | Uniform |

As shown in FIGS. 6 to 8 and Table 2, by using the etching solution with a plurality of aliphatic carboxylic acids mixed therein, the size of the pyramid-shaped protrusions of the uneven structure on the surface of the substrate can be regulated easily.

### (Example 8)

First, as shown in Table 3, an etching solution containing an alkali and an aliphatic carboxylic acid, with the balance thereof being water, was prepared. Using 6 L of the etching solution at a liquid temperature of 80°C to 85°C, a single crystal silicon substrate having a (100) plane on the surface was soaked for 30 minutes, and thereafter, the surface of the treated substrate was observed visually.

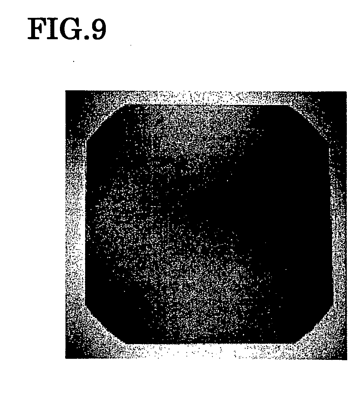

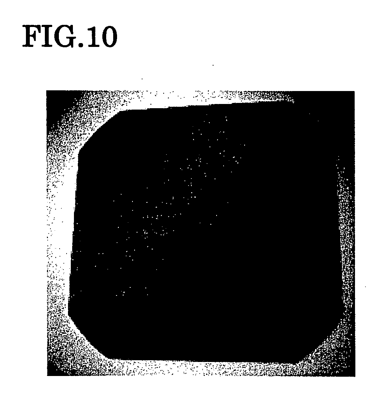

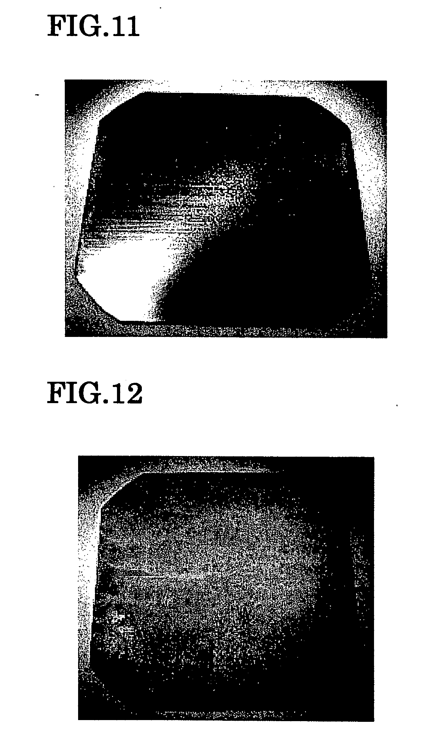

Table 3 shows the results of the visual observation. In Table 3, substrates with pyramid-shaped fine uneven structures formed on the surfaces were evaluated by being classified into three stages (uniformity: excellent > satisfactory > acceptable) in terms of the uniformity of unevenness. The substrates without fine uneven structures in a pyramid shape formed on the surfaces were determined to be failure. FIGS. 9 to 12 are photographs showing examples of the surfaces of the substrates whose evaluations are excellent, satisfactory, acceptable, and failure.

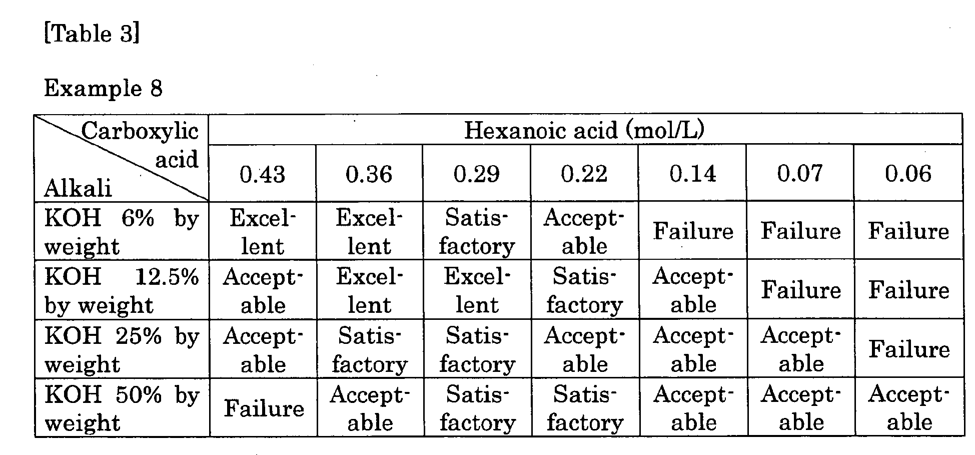

### (Example 9)

An experiment was conducted in the same way as in Example 8 except that an etching solution having a composition shown in Table 4 was used as an etching solution. Table 4 shows the results.

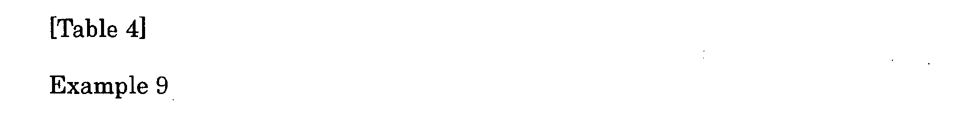

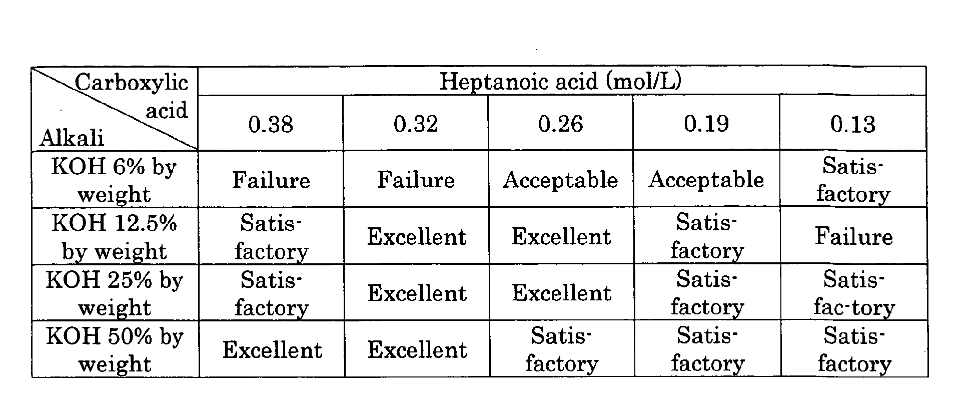

### (Example 10)

An experiment was conducted in the same way as in Example 8 except that an etching solution having a composition shown in Table 5 was used as an etching solution. Table 5 shows the results.

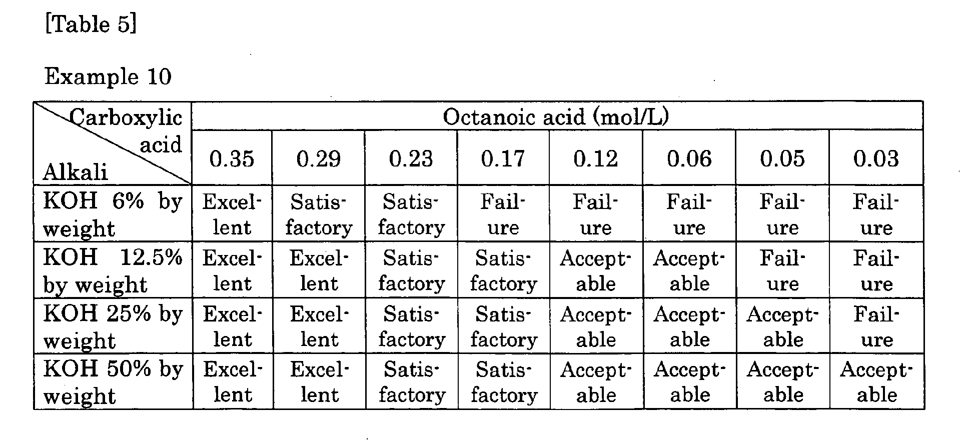

### (Example 11)

An experiment was conducted in the same way as in Example 8 except that an etching solution having a composition shown in Table 6 was used as an etching solution. Table 6 shows the results.

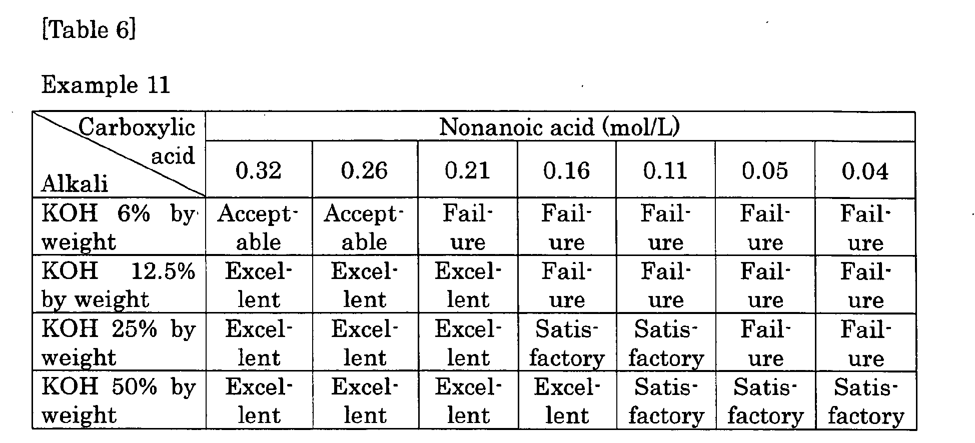

### (Example 12)

An experiment was conducted in the same way as in Example 8 except that an etching solution having a composition shown in Table 7 was used as an etching solution. Table 7 shows the results.

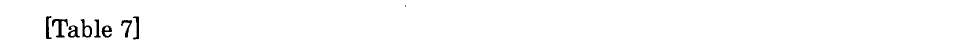

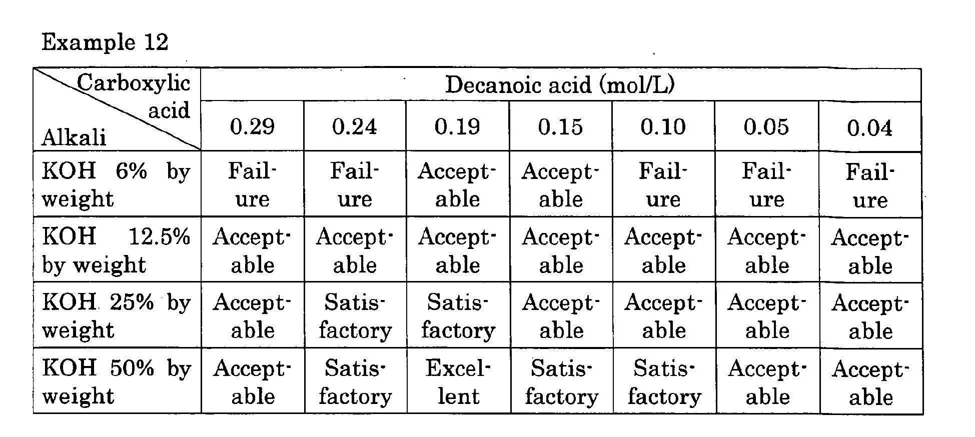

### (Example 13)

An experiment was conducted in the same way as in Example 8 except that an etching solution having a composition shown in Table 8 was used as an etching solution. Table 8 shows the results.

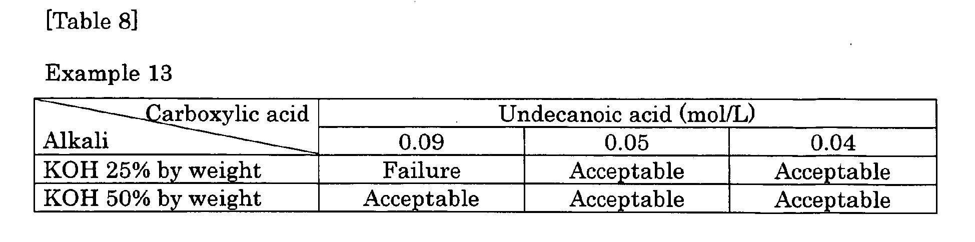

### (Example 14)

An experiment was conducted in the same way as in Example 8 except that an etching solution having a composition shown in Table 9 was used as an etching solution. Table 9 shows the results.

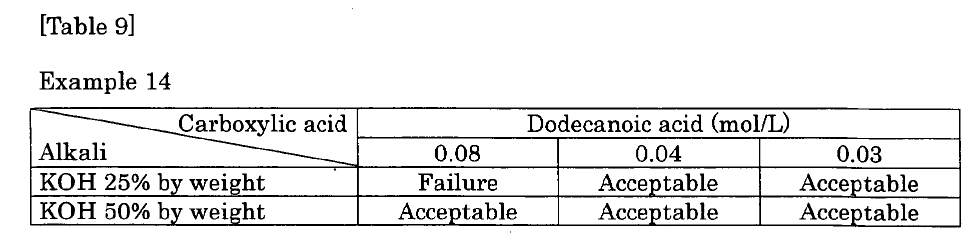

### (Example 15)

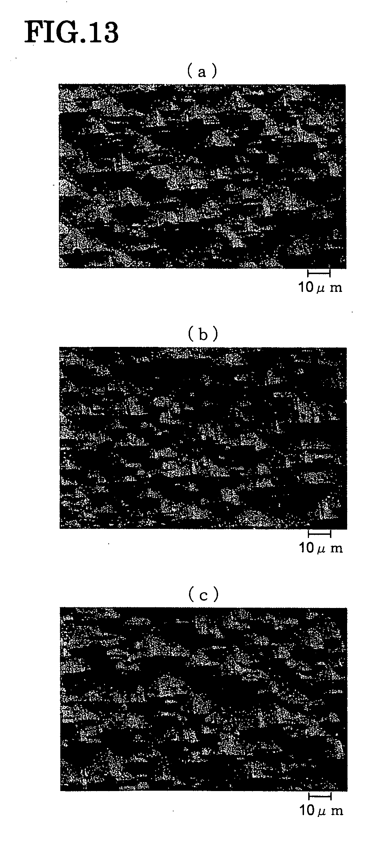

Using 6 L of a KOH aqueous solution (6% by weight) containing 200 g (about 0.55 mol/L) of acetic acid as an etching solution, a single crystal silicon substrate (weight: 7.68 g, thickness: 222 µm) having a (100) plane on the surface was soaked at 90°C to 95°C for 30 minutes, whereby a substrate (weight: 5.47 g, thickness: 171 µm) having fine unevenness on the surface was obtained. The surface of the treated substrate was observed in electron micrographs. FIG. 13 shows the results of the electron micrographs (magnification: 1,000, 3 portions). The maximum side length of a bottom surface of an uneven structure on the surface of the obtained substrate was 15.0 µm. Table 10 shows the results of Examples 15 to 18.

### (Example 16)

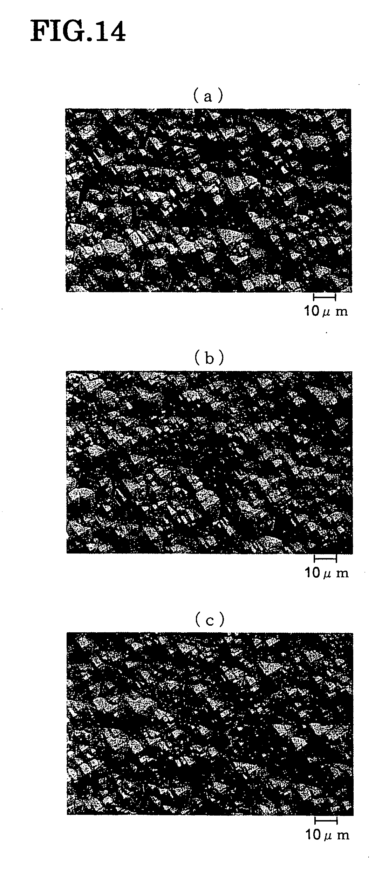

Using 6 L of a KOH aqueous solution (6% by weight) containing 200 g (about 0.17 mol/L) of citric acid as an etching solution, a single crystal silicon substrate (weight: 7.80 g, thickness: 227 µm) having a (100) plane on the surface was soaked at 90°C to 95°C for 20 minutes, whereby a substrate (weight: 6.44 g, thickness: 193 µm) having fine unevenness on the surface was obtained. FIG. 14 shows the results of the electron micrographs (magnification: 1,000, 3 portions). The maximum side length of a bottom surface of an uneven structure on the surface of the obtained substrate was 10.0 µm.

### (Example 17)

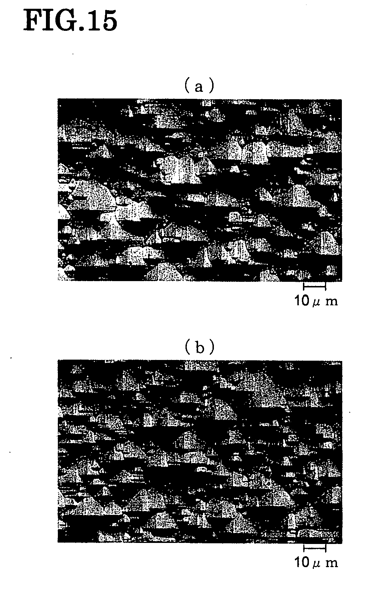

Using 6 L of a KOH aqueous solution (6% by weight) containing 300 g (about 0.69 mol/L) of acrylic acid as an etching solution, single crystal silicon substrates (SLOT 5, weight: 9.66 g, thickness: 279 µm, and SLOT 20, weight: 9.66 g, thickness: 283 µm) each having a (100) plane on the surface were soaked at 90°C to 95°C for 30 minutes, whereby substrates (SLOT 5, weight: 7.56 g, thickness: 239 µm, and SLOT 20, weight: 7.53 g, thickness: 232 µm) each having fine unevenness on the surface were obtained. FIG. 15 shows the results of the electron micrographs (magnification: 1,000). The maximum side length of bottom surfaces of uneven structures on the surfaces of the obtained substrates was 17.0 µm.

### (Example 18)

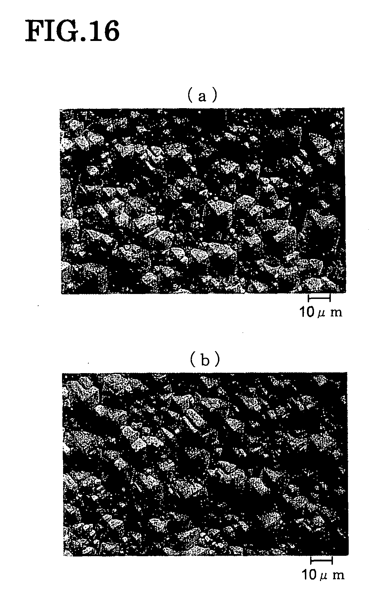

Using 6 L of a KOH aqueous solution (6% by weight) containing 200 g (about 0.37 mol/L) of oxalic acid as an etching solution, single crystal silicon substrates (SLOT 5, weight: 9.60 g, thickness: 289 µm, and SLOT 20, weight: 9.65 g, thickness: 285 µm) each having a (100) plane on the surface were soaked at 90°C to 95°C for 30 minutes, whereby substrates (SLOT 5, weight: 7.60 g, thickness: 239 µm, and SLOT 20, weight: 7.60 g, thickness: 244 µm) each having fine unevenness on the surface were obtained. FIG. 16 shows the results of the electron micrographs (magnification: 1,000, 3 portions). The maximum side length of bottom surfaces of uneven structures on the surfaces of the obtained substrates was 15.0 µm.

**[Table 10]**

| | Composition of etching solution | | Unevenness of substrate | |
|---|---|---|---|---|
| | Carboxylic acid | KOH concentration | Maximum side length of bottom surface | Uniformity |
| Example 15 | Acetic acid | 6% | 15.0 µm | Uniform |
| Example 16 | Citric acid | 6% | 10.0 µm | Uniform |
| Example 17 | Acrylic acid | 6% | 17.0 µm | Uniform |
| Example 18 | Oxalic acid | 6% | 15.0 µm | Uniform |

## Claims

1. A process for producing a semiconductor substrate, comprising etching a semiconductor substrate with an alkaline etching solution containing at least one kind selected from the group consisting of carboxylic acids having a carbon number of 1 to 12 and having at least one carboxyl group in one molecule, and salts thereof, to thereby form an uneven structure on a surface of the semiconductor substrate.

2. The process for producing a semiconductor substrate according to claim 1, wherein the carboxylic acid is one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

3. The process for producing a semiconductor substrate according to claim 1 or 2, wherein the carboxylic acid has a carbon number of 7 or less.

4. The process for producing a semiconductor substrate according to any one of claims 1 to 3, wherein the etching solution contains the carboxylic acid in a concentration of 0.05 to 5 mol/L.

5. The process for producing a semiconductor substrate according to any one of claims 1 to 4, further comprising selecting a predetermined one or two or more kinds of carboxylic acids as the carboxylic acid in the etching solution, to thereby regulate a size of a pyramid-shaped protrusion of an uneven structure formed on the surface of the semiconductor substrate.

6. A semiconductor substrate for solar application comprising an uneven structure on a surface thereof, which is produced by the method according to any one of claims 1 to 5.

7. The semiconductor substrate for solar application according to claim 6, further comprising a uniform and fine uneven structure in a pyramid shape on the surface thereof, wherein the uneven structure has a bottom surface which has a maximum side length of 1 um to 20 µm.

8. The semiconductor substrate for solar application according to claim 6 or 7, wherein the semiconductor substrate is a thinned single crystal silicon substrate.

9. An etching solution for uniformly forming a fine uneven structure in a pyramid shape on a surface of a semiconductor substrate, which is an aqueous solution containing an alkali and a carboxylic acid having a carbon number of 12 or less and having at least one carboxyl group in one molecule.

10. The etching solution according to claim 9, wherein the etching solution contains 3 to 50% by weight of the alkali, 0.05 to 5 mol/L of the carboxylic acid, and the balance of water.

11. The etching solution according to claim 9 or 10, wherein the carboxylic acid is one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

12. The etching solution according to any one of claims 9 to 11, wherein the carboxylic acid has a carbon number of 7 or less.
